# EUROPEAN PATENT SPECIFICATION

(11) **EP 4 331 803 B1**
(45) Date of publication and mention of the grant of the patent: **04.12.2024**
(21) Application number: 23190597.7
(22) Date of filing: 09.08.2023
(51) Int. Cl.: B29C 33/30, B29C 33/38, B29C 33/40, B29C 33/42, B29C 43/02, B29C 35/08, G03F 7/00

(54) **MOLD AND METHOD OF MANUFACTURING STRUCTURE**
FORM UND VERFAHREN ZUR HERSTELLUNG EINER STRUKTUR
MOULE ET PROCÉDÉ DE FABRICATION D'UNE STRUCTURE

(30) Priority: 30.08.2022 JP 2022137293
(43) Date of publication of application: 06.03.2024
(73) Proprietor: FUJIFILM Corporation, Tokyo 106-8620 (JP)
(72) Inventor: UMEZAWA, Tomokazu, Minamiashigara, 250-0193 (JP)
(74) Representative: Meissner Bolte Partnerschaft mbB

(56) References cited:
- WO-A1-2016/013452
- JP-A- 2021 512 587
- US-A1- 2010 096 770
- US-A1- 2010 096 777

## Description

### BACKGROUND OF THE INVENTION

### 1. Field of the Invention

The present disclosure relates to a mold and a method of manufacturing a structure.

### 2. Description of the Related Art

Various techniques of performing surface treatment on a microstructre formed on a substrate have been studied.

JP2010-18044A describes a method of manufacturing fine particles. In the method, fine particles made of a fine particle material are formed on at least a part of uneven portions formed by arranging a plurality of projected portions on one surface of a substrate with reference to the surface. The formation of the fine particles is performed by vacuum vapor deposition. The vacuum vapor deposition is performed by making an uneven portion side of a substrate, which has an uneven portion formed on the surface thereof, face the vacuum vapor deposition direction and setting an angle of the substrate with respect to the vertical direction in a range of 1 degree to 80 degrees.

JP1999-339649A (JP-H11-339649A) describes a method of manufacturing a glass substrate for a flat display device. In the method, the following steps are performed in this order: a partition wall formation step of forming a plurality of partition walls on the glass substrate and a conductive material on a glass substrate surface corresponding to a lower portion of each room partitioned by the partition walls; and an electrode formation step of forming the electrode by vapor deposition. US 2010/096777 A1 discloses three-dimensional micro-mechanical devices made by using a production casting process. As part of this process, an intermediate mold is made from a stack lamination.

### SUMMARY OF THE INVENTION

The surface treatment may be performed only on a part of the microstructre formed on the substrate.

However, in the prior art of surface treatment as applied to JP2010-18044A and JP1999-339649A (JP-H11-339649A), it has been difficult to locally and accurately perform surface treatment only on a part of the surface of the microstructure.

The present disclosure has been made in consideration of the circumstances described above.

An embodiment of the present disclosure has an object to provide a mold capable of forming a microstructre and surface treatment on a part of a surface of the structure, or a method of manufacturing a structure using the mold.

The present invention is defined by independent claim 1 as appended. Further preferable embodiments are given in the dependent claims.

According to an embodiment of the present disclosure, there is provided a mold capable of forming a microstructre and surface treatment on a part of a surface of the structure, or a method of manufacturing a structure using the mold.

### BRIEF DESCRIPTION OF THE DRAWINGS

Fig. 1 is a schematic cross-sectional view showing an example of a mold according to the present disclosure.
Fig. 2Ais a top view showing an example of a first member.
Fig. 2B is a schematic cross-sectional view taken along the line 1-1 of the first member shown in Fig. 2A.
Fig. 3A is a top view showing an example of a second member.
Fig. 3B is a schematic cross-sectional view taken along the line 2-2 of the second member shown in Fig. 3A.
Fig. 4 is a schematic cross-sectional view showing another example of the mold according to the present disclosure.
Fig. 5 is a schematic cross-sectional view showing another example of the mold according to the present disclosure.
Fig. 6Ais a schematic cross-sectional view showing an example of a mold in which a room separate from the room defined by the mold wall is formed.
Fig. 6B is a diagram for explaining an angle α and an angle β.
Fig. 7 is a schematic cross-sectional view showing another example of the mold according to the present disclosure.
Fig. 8 is a schematic cross-sectional view showing an example of the mold in which the first member and the second member are immobilized by using magnetic force.
Fig. 9 is a schematic cross-sectional view showing an example in which a release layer is formed on the second member.
Fig. 10 is a schematic cross-sectional view showing an example in which a release layer is formed on the first member and the second member.
Fig. 11 is a schematic cross-sectional view showing an example in which a release layer is formed on the first member and the second member.
Fig. 12 is a schematic cross-sectional view for explaining an example of the mold in which the second member is formed of a light transmittance material.
Fig. 13 is a schematic cross-sectional view showing an example of the mold having an alignment portion.
Figs. 14A to 14G are diagrams for explaining an example of a method of manufacturing the structure according to the present disclosure.
Figs. 15A to 15G are diagrams for explaining another example of the method of manufacturing the structure according to the present disclosure.
Fig. 16 is a schematic cross-sectional view showing an example of an aspect in which
a substrate and the first member are separated from each other by using an extrusion member.

### DESCRIPTION OF THE PREFERRED EMBODIMENTS

Hereinafter, embodiments of the present disclosure will be described with reference to the accompanying drawings. The present disclosure is not limited in any way to the following embodiments and may be implemented with appropriate modifications within the scope of the purpose of the present disclosure. The constitutional elements indicated by the same reference numerals in the drawings mean the same constitutional elements. The description of redundant constitutional elements and reference numerals in the respective drawings may be omitted. A dimensional ratio in the drawings does not necessarily represent the actual dimensional ratio.

In the present disclosure, a range of numerical values described using "to" means a range including the numerical values listed before and after "to" as the lower limit value and the upper limit value. In the numerical range described stepwise in the embodiment of the present disclosure, an upper limit value or a lower limit value described in a certain numerical range may be replaced with an upper limit value or a lower limit value of another numerical range described stepwise. Further, in the numerical range described in the embodiment of the present disclosure, the upper limit value or the lower limit value described in a certain numerical range may be replaced with a value shown in examples.

### Mold

According to the present disclosure, a mold for structure shaping includes: a first member that has two main surfaces and a through-hole which penetrates through the main surfaces; and a second member that blocks the through-hole. The first member and the second member are combined such that a wall surface A, which is a part of a surface of the first member, and a wall surface B, which is a part of a surface of the second member, are made continuous to form a mold wall.

The mold according to the present disclosure is a mold used for shaping a structure using a transfer material, and can be suitably used for shaping a microstructure. Here, in the present disclosure, the "microstructure" means a structure which is processed to have a size of nano-order or micron-order. Examples of the structure shaped by using the mold according to the present disclosure include a structure having a maximum length of 100 nm to 1000 µm. In addition, a structure having a maximum length of 5 µm to 200 µm is preferable. Examples of the structure include a microchannel, a cell culture vessel, a microlens array, a micromirror, and the like.

As described above, in the conventional method as described in JP2010-18044A or JP1999-339649A (JP-H11-339649A), it has been difficult to locally and accurately perform surface treatment on only a part of the surface of the microstructure. Therefore, the present inventor of the present invention has addressed a configuration of a mold for structure shaping. The present inventor has found that a microstructre can be formed and a part of the surface of the structure can be subjected to surface treatment, by using the mold according to an embodiment of the present disclosure which has both a function of shaping the structure and a function of a mask in performing surface treatment.

In the mold according to the embodiment of the present disclosure, one mold is formed by combining a first member having two main surfaces and a through-hole which penetrates through the main surfaces and a second member blocking the through-hole. A mold wall is formed by continuously forming a wall surface A which is a part of the surface of the first member and a wall surface B which is a part of the surface of the second member.

Here, in the present disclosure, the "mold wall" means a surface of the surfaces of the mold that comes into contact with the transfer material and contributes to the shaping of the transfer material.

In the present disclosure, the wall surface A means a surface of the surfaces of the first member that comes into contact with the transfer material, and the wall surface B means a surface of the surfaces of the second member that comes into contact with the transfer material.

Further, in the present disclosure, the phrase "the wall surface A and the wall surface B are made continuous to form a mold wall" means that a mold wall is formed by making the wall surface A and the wall surface B come in contact with each other to form one surface. Specifically, in the step of manufacturing the structure, the wall surface A and the wall surface B may be in contact with each other to such an extent that the transfer material shaped by the molding does not leak from the contact portion between the wall surface A and the wall surface B.

In an embodiment of the mold according to the present disclosure, the first member and the second member may be combined such that the wall surface A is a surface of the through-hole of the first member and the wall surface A and the wall surface B are made continuous to form the mold wall. (Hereinafter, the mold according to this embodiment is also appropriately referred to as a "mold A").

In another embodiment of the mold according to the present disclosure, the second member has a protrusion portion which penetrates and plugs the through-hole of the first member and of which a length in a cross-sectional view in a thickness direction is greater than a length of the through-hole, the wall surface B includes a surface of the protrusion portion, and the first member and the second member are combined such that the wall surface A and the wall surface B are made continuous to form the mold wall. (Hereinafter, the mold according to this embodiment is also appropriately referred to as a "mold B").

In the following description, in a case where the mold according to the embodiment is also simply referred to as a "mold", the term "mold" is used to include both the mold A and the mold B.

After shaping the structure from the transfer material using the mold according to the present disclosure, the first member and the second member are separated from each other, and the second member is removed. In such a case, a part of the structure is exposed from the through-hole of the first member. Since the first member after removing the second member can be used as a mask in performing surface treatment on the structure, it is possible to locally and accurately perform the surface treatment only on the surface of the structure exposed from the through-hole of the first member without using a separate mask.

Hereinafter, embodiments of the present disclosure will be described, with reference to the drawings as appropriate.

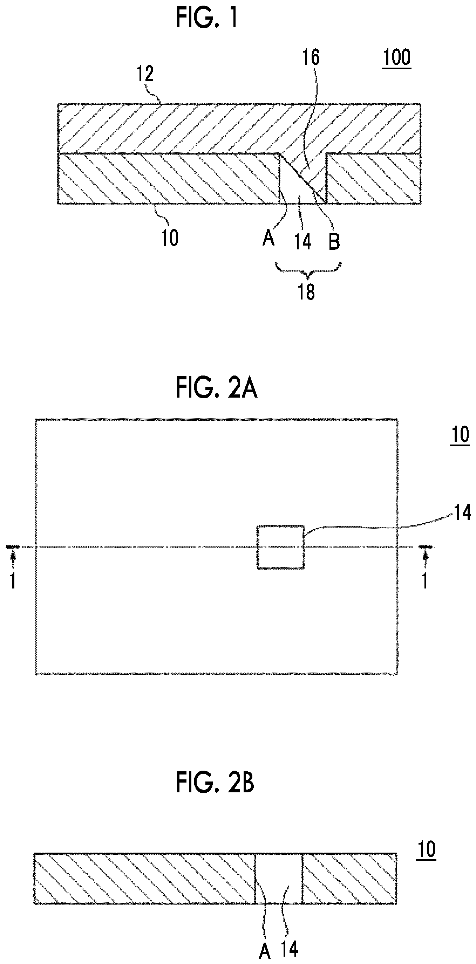

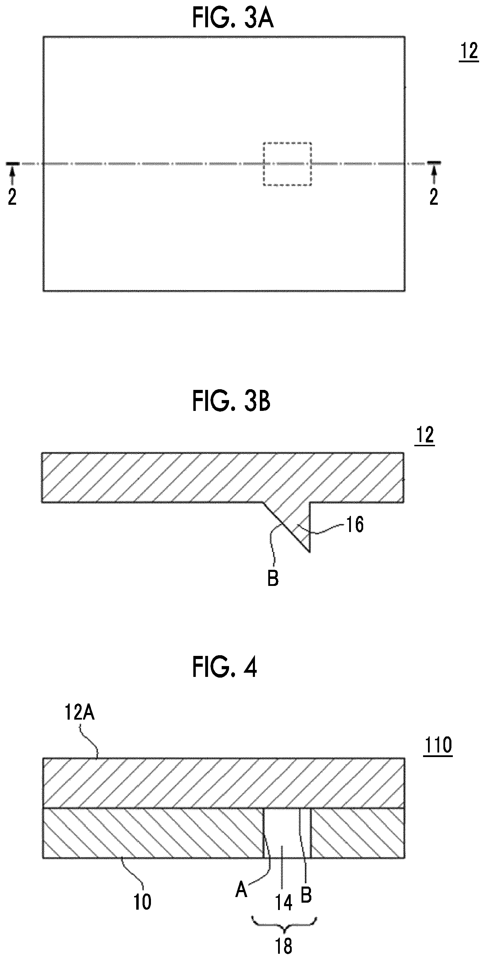

Fig. 1 is a schematic cross-sectional view showing a mold 100 according to an embodiment of the mold A. Fig. 2A is a top view of the first member 10 of the mold 100, and Fig. 2B is a schematic cross-sectional view taken along the line 1-1 of the first member 10 shown in Fig. 2A. Fig. 3A is a top view of the second member 12 of the mold 100, and Fig. 3B is a schematic cross-sectional view taken along the line 2-2 of the second member 12 shown in Fig. 3A.

As shown in Fig. 1, the mold 100 is configured as one mold by combining the first member 10 and the second member 12. The first member 10 is a member having two main surfaces and has a through-hole 14 which penetrates the two main surfaces. In the mold 100, the wall surface A of the through-hole 14 of the first member 10 and the wall surface B which is a part of the surface of the second member 12 are made continuous to form the mold wall. The mold wall, which is formed by the wall surface A and the wall surface B of the mold 100, regulates the transfer material (not shown in the drawing) filled in the through-hole 14 to shape the structure. The second member has a fitting portion 16 that is fitted into the through-hole 14 of the first member 10.

As shown in Figs. 2A and 2B, the first member 10 is a member having two main surfaces and has the through-hole 14 which penetrates the two main surfaces. The two main surfaces of the first member mean two flat surfaces facing each other in the thickness direction of the first member.

In the mold 100, a region including the mold wall, in which the wall surface A and the wall surface B are continuously formed, constitutes a pattern portion 18. The pattern portion 18 defines a shape and a size of the structure formed by using the mold 100. In the first member 10, the through-hole 14 is formed in a square column shape. However, the shape of the through-hole 14 is not limited to this, and may be a desired shape such as a columnar shape, a barrel shape, a polygonal column shape other than a square column shape, or a linear pattern.

The first member 10 has one through-hole 14, but in the mold A according to the present disclosure, the first member may have only one through-hole or two or more through-holes.

Further, a penetration length of the through-hole can be appropriately determined in accordance with the target structure. From the viewpoint of releasability of the structure in forming the microstructre, the penetration length may be, for example, in a range of 100 nm to 1000 µm, and preferably in a range of 5 µm to 200 µm.

An aspect ratio, which is a penetration length with respect to an opening width of the through-hole, can be appropriately determined in accordance with the target structure. From the viewpoint of releasability of the structure, the aspect ratio may be, for example, in a range of 0.5 to 50, and is preferably in a range of 1 to 20.

The second member 12 is a member that blocks the through-hole 14 of the first member 10, and shapes one end (that is, a ceiling part of the structure) of the structure formed by filling the through-hole 14 with a transfer material (not shown in the drawing) in the mold 100.

As shown in Fig. 1, the second member 12 has the fitting portion 16 that is fitted into the through-hole 14 of the first member 10, and the wall surface B may include the surface of the fitting portion 16. In a case where the second member 12 has the fitting portion 16, a structure having an inclined surface is shaped, and the second member 12 is separated and removed from the first member 10, and thereafter surface treatment can be locally and accurately performed on an inclined surface by using the first member 10 as a mask.

In the mold 100, the fitting portion 16 is fitted into the inside of the through-hole 14 such that a part of the surface of the fitting portion 16 comes into contact with a part of the inner surface of the through-hole 14. However, the fitting portion may be fitted into the inside of the through-hole such that the surface of the fitting portion does not come into contact with the inner surface of the through-hole.

The second member may have an aspect that does not have a fitting portion. Fig. 4 is a schematic cross-sectional view showing another example of the mold A according to an embodiment of the present disclosure. The mold 110 shown in Fig. 4 is a modification example having the same configuration as the mold 100 except that the second member 12 is changed to the second member 12A which has no fitting portion in the mold 100. As shown in Fig. 4, the second member 12A is a planar member that does not have a fitting portion. In the mold 110, the entire surface of the through-hole 14 of the first member 10 constitutes the wall surface A, and the surface of the second member 12A that blocks the through-hole 14 constitutes the wall surface B. A region including the mold wall formed by continuously forming the wall surface A of the first member 10 and the wall surface B of the second member 12A constitutes the pattern portion 18.

The first member may have one or two or more recessed portions (non-through-holes) that do not penetrate one of the two main surfaces, in addition to the through-holes. In a case where the first member is provided with the non-through-hole, a structure to be subjected to the surface treatment and a structure not to be subjected to the surface treatment can be formed by using one mold.

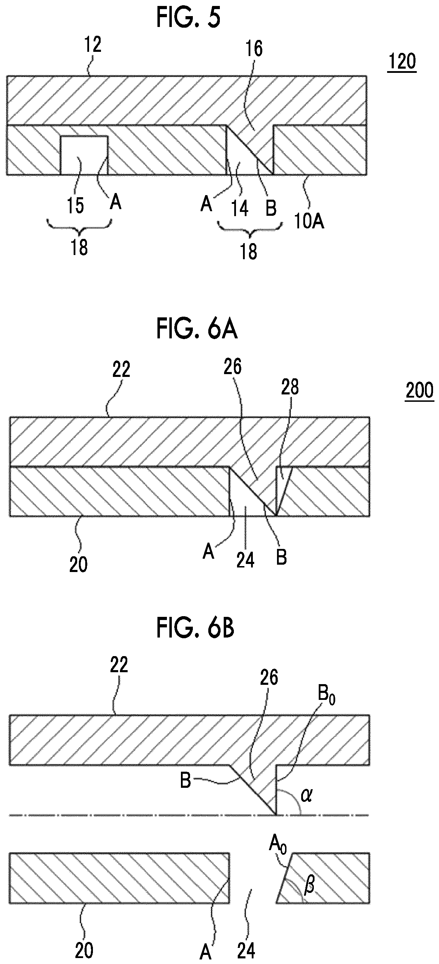

The mold 120 shown in Fig. 5 is a modification example having the same configuration as the mold 100 except that the first member 10 is changed to the first member 10A including the through-hole 14 and a non-through-hole 15. As shown in Fig. 5, the mold 120 includes the pattern portion 18 including the through-hole 14 and the pattern portion 18 including the non-through-hole 15. In the pattern portion 18 including the through-hole 14, the wall surface A which is a part of the surface of the through-hole 14 of the first member 10A and the wall surface B which is a part of the surface of the second member 12 are made continuous to form the mold wall. In the pattern portion 18 including the non-through-hole 15, the wall surface A, which is the entire surface of the non-through-hole 15 of the first member 10A, constitutes the mold wall.

In the mold A according to the present disclosure, the through-hole of the first member and the fitting portion of the second member may further form a room separate from the room defined by the mold wall. By forming the room separate from the room defined by the mold wall, the first member and the second member can be easily separated from each other.

Fig. 6A is a schematic cross-sectional view showing an example of the mold A in which a room separate from the room defined by the interior wall of the mold is formed. As shown in Fig. 6, the mold 200 is configured by combining a first member 20 having a through-hole 24 and a second member 22 having a fitting portion 26. A room 28 is formed separately from the room defined by the mold wall formed from the wall surface A of the through-hole 24 and the wall surface B which is a part of the surface of the fitting portion 26.

Specifically, in the cross-sectional view of the mold A in the thickness direction, assuming that an angle formed between a wall surface B₀ on a side of the separate room of the fitting portion and an imaginary straight line, which passes through the top of the fitting portion and is parallel to a fitting portion formation surface of the second member, is α, and an angle formed between a wall surface A₀ on a side of the separate room of the through-hole and one main surface of the first member with which the second member is combined is β, the angle α and the angle β can be formed by satisfying the relationship of α > β.

The angle α, the angle β, and the relationship thereof will be specifically described with reference to Figs. 6A and 6B. Fig. 6B is a schematic cross-sectional view showing a state in which the first member and the second member are separated in the mold 200 shown in Fig. 6A.

As shown in Fig. 6B, in a case where the first member 20 and the second member 22 are combined, the angle α is an angle formed by the wall surface B₀ on the side of the room 28 of the second member 22 and the imaginary straight line (one-point chain line in Fig. 6B) that passes through the apex of the fitting portion 26 and is parallel to the fitting portion formation surface of the second member 22. Further, in a case where the first member 20 and the second member 22 are combined, the angle β is an angle formed by the wall surface A₀ on the side of the separate room 28 of the through-hole 24 and one main surface of the first member 20 in which the second member 22 is combined.

Since the angle α and the angle β satisfy the relationship of α > β, the room 28 is formed in a case where the first member 20 and the second member 22 are combined to constitute the mold 200 as shown in Fig. 6A. The room 28 is formed between the first member 20 and the second member 22, and a non-contact portion is present. Therefore, in a case where external force is applied to separate the first member and the second member, the first member 20 and the second member 22 are easily separated from each other starting from the region of the room 28. Thus, the first member and the second member are easily separated from each other.

Magnitudes of the angle α and the angle β may be appropriately determined to satisfy the relationship of α > β. From the viewpoint of ease of the separation between the first member and the second member, for example, it is also preferable that 1° < α - β < 30°.

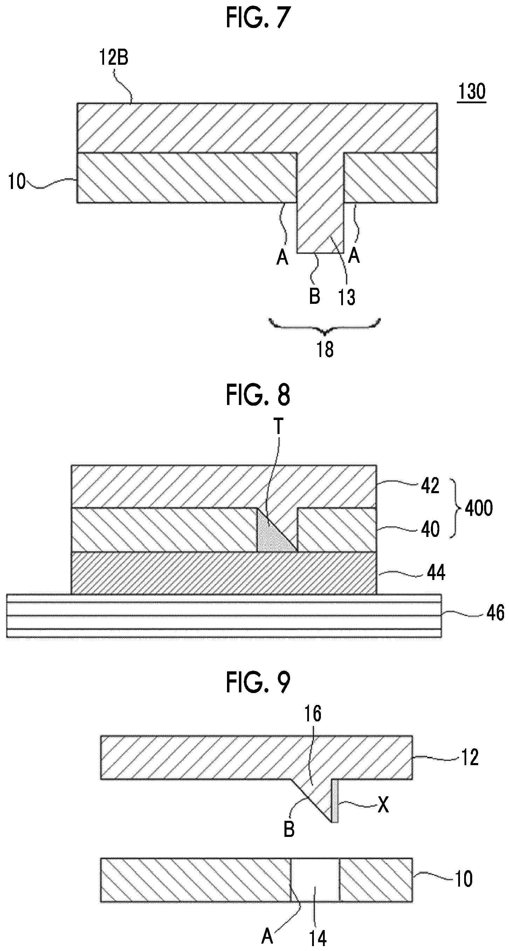

Fig. 7 is a schematic cross-sectional view showing the mold 130 according to the embodiment of the mold B. As shown in Fig. 7, the mold 130 is configured as one mold by combining the first member 10 and the second member 12B.

The first member 10 is the same member as the first member 10 constituting the mold 100. In Fig. 7, the reference numerals of through-holes of the first member 10 are omitted. The second member 12B has a protrusion portion 13 of which the length in the cross-sectional view in the thickness direction is greater than the length of a through-hole of the first member 10, and the protrusion portion 13 penetrates and plugs the through-hole of the first member 10. That is, a part including the tip part of the protrusion portion 13 that plugs the through-hole of the first member 10 protrudes from the main surface of the first member 10 on the side opposite to the second member 12B side.

In the mold 130, the main surface on the side opposite to the second member 12B side in the two main surfaces of the first member 10 constitutes the wall surface A. The wall surface A and the wall surface B which is a part of the surface of the protrusion portion 13 of the second member 12B are made continuous to form the mold wall. In the mold 130, the pattern portion 18 is constituted by a region which includes the mold wall formed by continuously forming the wall surface A including the main surface on a side opposite to the second member 12B side and the wall surface B which is a part of the surface of the protrusion portion 13.

In the mold 130, a transfer material (not shown in the drawing) may be disposed on a side of the first member 10 opposite to the second member 12B side, and the transfer material can be regulated by the formed mold wall to shape the structure. By using the mold 130, it is possible to obtain a structure having a recessed portion (for example, a groove portion).

In addition, the mold according to the present disclosure may have only a configuration of the mold A or a configuration of the mold B, or may have a configuration of both the mold A and the mold B.

The material for forming the first member and the second member is not particularly limited as long as the material is a material applicable to the formation of the mold, and may be an inorganic material or an organic material.

Examples of the inorganic material include a metal material, a glass material, and a ceramic material. Examples of the metal material include nickel, copper, and an alloy including two or more of the metals. Examples of the glass material include quartz, and examples of the ceramic material include silicon carbide (SiC).

Examples of the organic material include an organic material including a resin. Examples of the resin include resins such as silicone, polydimethylsiloxane (PDMS), polycarbonate, and cycloolefin polymer (COP).

The first member and the second member can be manufactured by, for example, lithography such as cutting, laser exposure; dry etching or wet etching; electrocasting, molding using the organic material including the resin; and the like.

Further, as an aspect, the first member and the second member may be manufactured separately, and then the two members may be combined to form a mold, or as an aspect, the second member may be formed on the first member to form a mold. Examples of the aspect in which the second member is formed on the first member include an aspect in which the second member is formed on the first member manufactured in advance by using the coating method or the like.

The thicknesses of the first member and the second member can be appropriately set in accordance with the intended purpose. For example, the thicknesses of the first member and the second member can be independently set in a range of 10 µm to 10 mm and may be set in a range of 100 µm to 600 µm.

The materials for forming the first member and the second member may be the same or different.

From the viewpoint of manufacturability and cost, it is preferable that the first member and the second member are made of the same material.

The first member and the second member may be formed of materials which have different elastic moduli from each other. By using materials which have elastic moduli different from each other, the degree of bending with respect to external force applied in the case of separating the first member and the second member differs between the first member and the second member. Therefore, the first member and the second member are easily separated.

Examples of the materials which have different elastic moduli include an aspect in which one is an inorganic material including a metal and the other is an organic material including a resin.

In an aspect in which the mold is formed by using materials which have different elastic moduli, the elastic modulus of the material constituting the first member may be greater than the elastic modulus of the material constituting the second member, or the elastic modulus of the material constituting the first member may be less than the elastic modulus of the material constituting the second member. The elastic moduli of the materials constituting the first member and the second member can be appropriately set in accordance with the shape of the pattern portion of the mold, the type of the transfer material to be used, and the like.

In a certain aspect, from the viewpoint of facilitating peeling of the second member from the first member, it is preferable that the elastic modulus of the material constituting the first member is greater than the elastic modulus of the material constituting the second member. In another aspect, from the viewpoint of shape stability of the mold, it is preferable that the elastic modulus of the material constituting the first member is less than the elastic modulus of the material constituting the second member.

At least one of the first member or the second member may include a magnetic material, or both of the first member and the second member may include a magnetic material.

Examples of the magnetic material include metals such as nickel, cobalt, and iron, and alloys including two or more of the metals.

Since at least one of the first member or the second member includes the magnetic material, it is possible to improve immobilization between the first member and the second member or between the substrate on which the transfer material is disposed and the mold, by using the magnetic force from the outside.

In a certain aspect, the mold according to the present disclosure may be a mold in which the first member and the second member are immobilized by using the magnetic force. As the magnetic force, magnetic force generated from a magnet disposed outside the mold may be used. As the magnet, for example, a permanent magnet such as a neodymium magnet or an electromagnet can be used. The magnet may be disposed on either the first member side or the second member side of the mold.

Fig. 8 is a schematic cross-sectional view showing an example of the mold A in which the first member and the second member are immobilized by using the magnetic force. In the example shown in Fig. 8, a mold 400 in a state where a transfer material T is filled in the mold wall is disposed on a substrate 44 disposed on a permanent magnet 46.

In the example shown in Fig. 8, by forming both a first member 40 and a second member 42 with a magnetic material (for example, nickel), the first member 40 and the second member 42 are immobilized and closely attached by magnetic force. Thus, the transfer material T can be prevented from leaking to the outside of the mold wall (for example, a region where the first member 40 and the second member 42 are in surface contact with each other).

Further, in the example shown in Fig. 8, at least the first member 40 is formed of a magnetic material. Thereby, the first member 40 and the substrate 44 are immobilized and closely attached. Therefore, after the transfer material T is shaped to form a structure, the second member 42 is removed, and the surface treatment is performed on the exposed surface of the structure using the first member 40 as a mask. In such a case, the surface treatment can be accurately performed without separating the first member 40 from the substrate 44.

Further, in a case where the mold B is formed, it is preferable that both the first member and the second member are formed of a magnetic material (for example, nickel), and the magnet is disposed on a side opposite to the first member of the second member.

Each of the first member and the second member may have a release layer in at least a partial region of the surface. It is preferable to provide the release layer in that it is easy to perform separation between the first member and the second member, or separation between the first member and the structure or substrate on which the transfer material is shaped.

Examples of the aspect, in which the first member and the second member have the release layer, include aspects shown in (1) or (2) below, or may be both of the aspects shown in (1) and (2). Only one of the first member and the second member may have the release layer, or both of the first member and the second member may have the release layer.

Hereinafter, regarding Aspects (1) and (2), the form of the mold A will be specifically described with reference to the drawings in examples. However, it is needless to say that Aspects (1) and (2) can be applied to the form of the mold B.

Aspect (1): A form in which the release layer is provided in at least a partial region of a surface in which the first member and the second member are in contact with each other. According to Aspect (1), the releasability at the interface between the first member and the second member is improved, and the separation between the first member and the second member is easier.

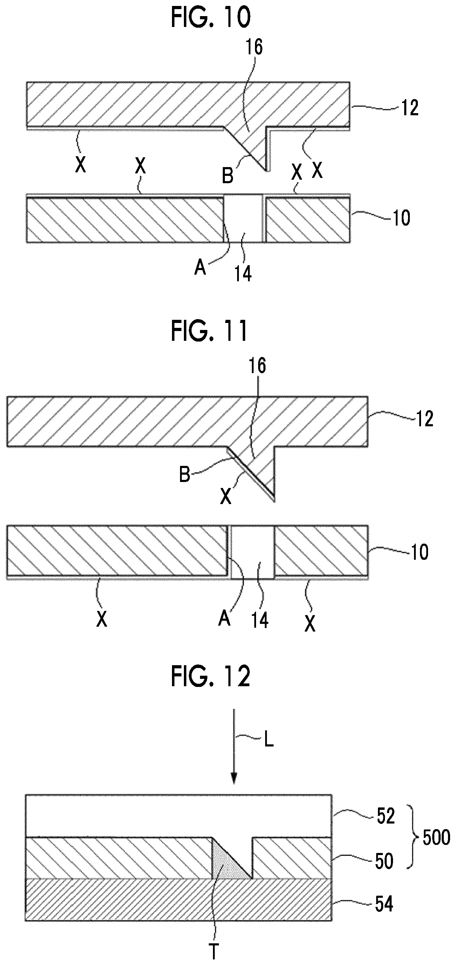

Figs. 9 and 10 are schematic cross-sectional views each showing an example in which the release layer according to Aspect (1) is provided in the first member 10 and the second member 12 of the mold 100 shown in Fig. 1, respectively.

In the example shown in Fig. 9, a release layer X is provided on the surface of the fitting portion 16 of the second member 12 in contact with the wall surface of the through-hole 14. Further, in the example shown in Fig. 10, the release layer X is provided on the entire surface of the surface in which the first member and the second member are in contact with each other.

Aspect (2): A form in which the release layer is provided in at least a partial region of a surface in which the first member and the second member are not in contact with each other. According to Aspect (2), the releasability between the first member and/or the second member and the structure shaped from the transfer material or the releasability between the first member and the substrate is improved, and separation of the 1-member and/or the second member from the structure or separation of the first member from the substrate is easier.

Fig. 11 is a schematic cross-sectional view showing an example in which the release layer according to Aspect (2) is provided in the first member 10 and the second member 12 of the mold 100 shown in Fig. 1. In the example shown in Fig. 11, the release layer X is provided on a surface in which the first member and the second member are not in contact with each other, that is, a surface (that is, the wall surface A) of the first member in contact with the transfer material (not shown in the drawing), a surface of the first member in contact with the substrate (not shown in the drawing), and a surface (that is, the wall surface B) of the second member 12 in contact with the transfer material.

The release layer can be formed of a fluorine-contained release agent, for example, perfluoropolyether (PFPE) or polytetrafluoroethylene (PTFE). Further, as the release layer, an aspect formed by using diamond-like carbon (DLC) is also appropriate.

In a case where a photocurable transfer material is applied as the transfer material, the second member may include a region that transmits light having at least a part of wavelengths in a range of wavelengths 200 to 400 nm. That is, the second member can be manufactured, for example, using the material that transmits light of at least a part of the wavelengths in the range of the wavelengths 200 to 400 nm (hereinafter, also referred to as a light transmittance material).

The region that transmits light of at least a part of the wavelengths in the range of wavelengths 200 to 400 nm may be at least a region corresponding to a position where the photocurable transfer material is disposed in the step of manufacturing the structure. At least a part of the second member may be manufactured using the light transmittance material, or the second member may be entirely manufactured using the light transmittance material.

There is an advantage in manufacturing the second member using a light transmittance material since exposure can be performed from the mold side in a case where a non-transparent substrate is used as the substrate on which the structure is provided.

Examples of the light transmittance material include a light transmittance resin material (for example, polydimethylsiloxane (PDMS), and cycloolefin polymer (COP)), quartz glass, and the like.

Fig. 12 is a schematic cross-sectional view for explaining an example of a mold in which the second member is formed of the light transmittance material. In the present example, a mold having the form of the mold A is used. In the example shown in Fig. 12, a mold 500 in which a first member 50 and a second member 52 are combined is disposed on a non-transparent substrate 54 in a state where the transfer material T is filled in the mold wall. In the present example, a photocurable transfer material is used as the transfer material T.

In the example shown in Fig. 12, the second member 52 is made of a light transmittance resin material (for example, polydimethylsiloxane (PDMS)). Therefore, by applying the light indicated by the arrow L from the second member 52 side, the transfer material T disposed on the non-transparent substrate 54 can be cured.

In the mold according to the present disclosure, it is preferable that at least one member of the first member and the second member has an alignment portion which aligns the members with each other. By providing the alignment portion, it is possible to accurately align the first member and the second member. The mold according to the present disclosure may have an alignment portion in any form of the mold A or the mold B.

It is preferable that the alignment portion has an aspect in which the first member and the second member are fitted to each other. From the viewpoint of accuracy of alignment, it is preferable that the alignment portion has an aspect in which one of the first member and the second member has a projected portion and the other thereof has a recessed portion.

The number of alignment portions may be one, but is preferably two or more from the viewpoint of improving an accuracy of alignment.

The alignment portion may be, for example, in a form in which one of the first member and the second member has a projected portion and the other thereof has a recessed portion or a penetration portion.

In a certain aspect of the mold A, from the viewpoint of improving the accuracy of alignment and not damaging the pattern portion, the second member has the fitting portion to be fitted into the through-hole of the first member. In the alignment portion, in the cross-sectional view in the thickness direction, it is preferable that the first member has a projected portion having a large length with respect to the length of the fitting portion of the second member and the second member has the recessed portion.

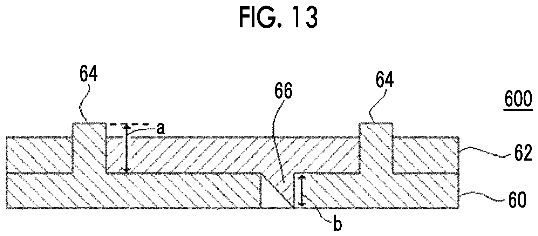

Fig. 13 is a schematic cross-sectional view showing an example of the mold A having the alignment portion. In the example shown in Fig. 13, the mold 600 has two alignment portions 64 composed of a projected portion of the first member 60 and a penetration portion as a recessed portion of the second member 62. A length a of the projected portion is configured to be greater than a length b of the fitting portion 66.

The mold according to the present disclosure may be used only once and then discarded, or may be repeatedly reused.

Next, a method of manufacturing the structure according to the present disclosure will be described.

### Method of Manufacturing Structure

A method of manufacturing the structure according to the present disclosure comprises the following steps:
a step (hereinafter, also referred to as a transfer material provision step) of providing the transfer material;
a step (hereinafter, also referred to as a shaping step) of shaping the transfer material on a substrate by using a mold for structure shaping, which has a first member that has two main surfaces and a through-hole which penetrates through the main surfaces and a second member that blocks the through-hole, and in which the first member and the second member are combined such that a wall surface A, which is a part of a surface of the first member, and a wall surface B, which is a part of a surface of the second member, are made continuous to form a mold wall;
a step (also referred to as an exposure step) of exposing a part of a surface of the structure shaped from the transfer material by removing the second member from the mold; and
a step (hereinafter, also referred to as a surface treatment step) of performing surface treatment on the exposed surface of the structure.

The method of manufacturing the structure according to the present disclosure is a method of manufacturing a structure using the above-mentioned mold according to the present disclosure. In the method, a microstructre can be formed and the surface treatment is formed on a part of the surface of the structure.

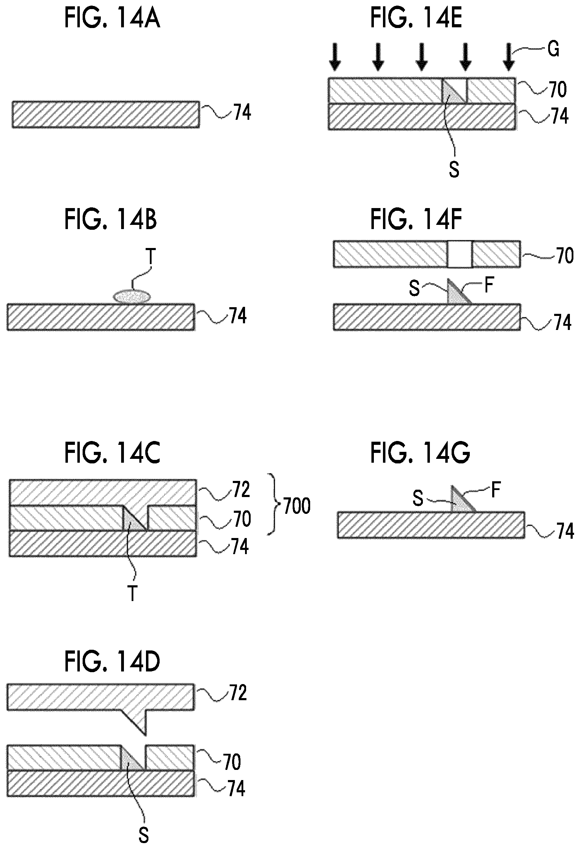

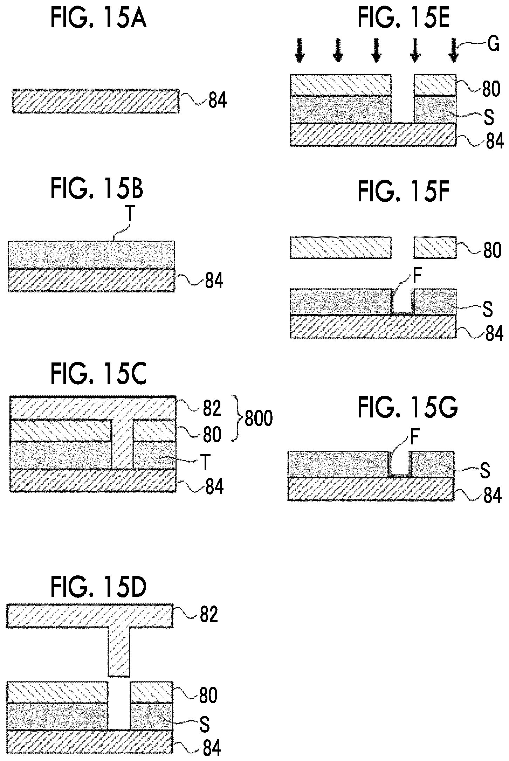

Hereinafter, embodiments of the method of manufacturing the structure according to the present disclosure will be described with reference to Figs. 14A to 14G and Figs. 15A to 15G as appropriate. Figs. 14A to 14G show examples in which the mold A is used. Figs. 15A to 15G are examples in which the mold B is used.

### Transfer Material Provision Step

In the transfer material provision step, a transfer material used for manufacturing the structure is provided. The transfer material may be manufactured from a raw material or a commercially available product on the market may be used.

It is preferable that examples of the transfer material include a radiation-curable composition, a photocurable composition, a thermosetting composition, a thermoplastic resin, and a photocurable composition. As the photocurable composition, an ultraviolet (UV) curable composition is preferable. Examples of the ultraviolet curable composition include PAK-01 and PAK-02 which are manufactured by Toyo Synthetic Industry Co., Ltd.

### Shaping Step

In the shaping step, the wall surface A that includes a first member that has two main surfaces and a through-hole which penetrates through the main surfaces, and a second member that blocks the through-hole, and the transfer material is shaped on the substrate by using the mold for structure shaping, in which the first member and the second member are combined such that the wall surface A, which is a part of the surface of the first member, and the wall surface B, which is a part of the surface of the second member, are made continuous to form the mold wall.

Since the details of the mold for structure shaping are the same as those of the above-mentioned mold (that is, the mold A or the mold B) according to the present disclosure, the description thereof will be omitted here.

An embodiment shown in Figs. 14A to 14G is an example in which the mold A is used, and a mold 700, in which a first member 70 and a second member 72 having the fitting portion are combined, is used.

An embodiment shown in Figs. 15A to 15G is an example in which the mold B is used, and a mold 800, in which a first member 80 and a second member 82 having the protrusion portions are combined, is used.

In the shaping step, first, a substrate is prepared.

In an embodiment shown in Figs. 14A to 14G, a substrate 74 is prepared as shown in Fig. 14A.

In an embodiment shown in Figs. 15A to 15G, a substrate 84 is prepared as shown in Fig. 15A.

The material of the substrate is not particularly limited as long as the material is a substrate that can be applied to manufacturing of the structure using the transfer material. Examples thereof include a glass substrate, a metal substrate, a resin substrate, and a substrate such as silicon (Si).

The substrate may be a substrate that has light transmittance or a substrate that has no light transmittance (that is, a non-transparent substrate).

In the shaping step, one aspect of shaping the transfer material on the substrate is to press the transfer material applied on the substrate using the mold.

For example, in a case where the mold A is used, as shown in Fig. 14B, the transfer material T is applied onto the substrate 74, and then the transfer material T may be pressed by using the mold 700 so as to have the configuration shown in Fig. 14C. Thereby, the shape of the pattern portion of the mold 700 is transferred to the transfer material T.

Further, in a case where the mold B is used, as shown in Fig. 15B, the transfer material T is applied onto the substrate 84, and then
the transfer material T may be pressed by using the mold 800 so as to have the configuration shown in Fig. 15C. Thereby, the shape of the pattern portion of the mold 800 is transferred to the transfer material T.

Examples of the transfer material application means in the present aspect include an inkjet, a spin coater, a gravure coater, and the like.

In another aspect of shaping the transfer material on the substrate, in the shaping step, the mold is filled with the transfer material and then the mold is disposed on the substrate.

The shaping step of the present aspect is performed using the mold A. Specifically, instead of applying the transfer material T onto the substrate 74 (Fig. 14B), the transfer material T is directly filled in the mold 700, and the mold 700 filled with the transfer material T may be disposed on the substrate 74 so as to have the configuration shown in Fig. 14C. The mold 700 filled with the transfer material T may be disposed on the substrate 74 and may be then further pressed. Thereby, the shape of the pattern portion of the mold 700 is transferred to the transfer material T.

In another aspect of shaping the transfer material on the substrate, in the shaping step, the first member disposed on the substrate is filled with the transfer material, the second member is disposed on the first member filled with the transfer material so as to form a mold, and the formed mold is pressed.

The shaping step of the present aspect is performed using the mold A. Specifically, instead of applying the transfer material T onto the substrate 74 (Fig. 14B), the first member 70 may be disposed on the substrate 74, the pattern portion having the through-hole of the first member 70 may be filled with the transfer material T, thereafter the second member 72 may be disposed on the first member 70 to assemble the mold 700, and then the mold 700 may be pressed so as to have the configuration shown in Fig. 14C. Thereby, the shape of the pattern portion of the mold 700 is transferred to the transfer material T.

Examples of the transfer material application means in the present aspect include an inkjet, a squeegee, and the like.

In the shaping step, it is also preferable that, in a case of disposing the first member on the substrate, the first member and the substrate are immobilized by using magnetic force.

As a method of immobilizing the first member and the substrate by using magnetic force, in a case where the mold A is used, in the same manner as in the example shown in Fig. 8, the magnet may be disposed on the side opposite to the side of the first member 70 of the substrate 74, in Fig. 14C. Further, in a case where the mold B is used, the magnet may be disposed on the side of the second member 82 opposite to the side of the first member 80, in Fig. 15C.

In the shaping step, it is preferable that the transfer material is cured. The curing preferably includes at least one selected from a group consisting of curing and photocuring having a curing temperature of -65°C or higher and 300°C or lower, and more preferably includes photocuring.

In the photocuring, a photocurable composition (preferably, a UV curable composition) is used as the transfer material T, the transfer material T and the mold are brought into contact with each other, and then exposure is performed with light having a wavelength of 200 to 400 nm. Exposure conditions and exposure means may be appropriately selected in accordance with the photocurable composition to be used. Examples of the photocurable composition include PAK-01 and PAK-02 which are manufactured by Toyo Synthetic Industry Co., Ltd.

In a case where the photocuring is applied to the curing of the transfer material, the exposure may be performed in order from the substrate side or the mold side. In a case where the mold B is used, it is preferable that exposure can be performed in order from the substrate side. In a case of exposure from the substrate side, the substrate is a light transmittance substrate. In a case of exposure in order from the mold side, the second member may be manufactured using a light transmittance material. An example of the mold, in which the second member is formed of the light transmittance material, is as described above with reference to Fig. 12.

As the curing in the shaping step, it is also preferable that the curing temperature is -65°C or higher and 300°C or lower. The transfer material T used in this aspect can include thermoplastic resin or thermosetting resin.

In a case where the transfer material T including the thermosetting resin is used, the transfer material T (thermosetting resin or thermosetting resin composition) is brought into contact with the mold and then the transfer material T is heat-cured. Heating conditions and heating means may be appropriately selected in accordance with the transfer material T to be used. Examples of the thermosetting resin include polydimethylsiloxane (PDMS) and epoxy resin.

In a case where the transfer material T (that is, thermoplastic resin or thermoplastic resin composition) including the thermoplastic resin is used, injection molding can be used in the shaping step. In such a case, the transfer material T can be cured by melting the transfer material T including thermoplastic resin such as polycarbonate or cycloolefin polymer (COP), injecting the transfer material T into the mold tool in which the mold is set and filling the mold tool with the transfer material T, and cooling and solidifying the transfer material T.

### Exposure Step

In the exposure step, the second member is removed from the mold to expose a part of the surface of the structure shaped from the transfer material.

In a case where the mold A is used, for example, as shown in Fig. 14D, the first member 70 is separated from the second member 72 and the second member 72 is removed. Thereby, a part of the surface of the structure S shaped from the transfer material T after the shaping step is exposed from the through-holes of the first member 70.

In a case where the mold B is used, as shown in Fig. 15D, the first member 80 and the second member 82 are separated from each other, and the second member 82 is removed. Thereby, a part of the surfaces of the substrate 84 and the structure S shaped from the transfer material T after the shaping step is exposed under the through-hole of the first member 80.

Means for separating the first member 70 and the second member 72 to remove the second member 72 is not particularly limited, and examples thereof include peeling removal using a hand or an operating device, dissolution removal using a solvent, and the like. The same applies to the means for separating the first member 80 and the second member 82 to remove the second member 82.

### Surface Treatment Step

In the surface treatment step, surface treatment is performed on the exposed surface of the structure.

The surface treatment is preferably performed without separating the first member and the structure, and the surface treatment is more preferably performed on the surface of the exposed structure by using the first member as a mask. Through the surface treatment step, the surface treatment layer is locally formed on a part of the surface of the shaped structure or a part of the surface of the structure and the substrate.

In a case where the mold A is used, for example, as shown in Fig. 14D, the first member 70 and the second member 72 are separated. Then, as shown in Fig. 14E, the first member 70 and the structure S are not separated, and the surface treatment indicated by the arrow G is performed on the exposed surface of the structure S by using the first member 70 as a mask. Thereby, even on an inclined exposed surface of the structure S, local surface treatment can be performed with high accuracy. Through the surface treatment, the surface treatment layer F is locally formed only on a part of the surface of the structure S.

In a case where the mold B is used, for example, as shown in Fig. 15D, the first member 80 and the second member 82 are separated. Then, as shown in Fig. 15E, the first member 80 and the structure S are not separated, and the surface treatment indicated by the arrow G is performed on the exposed surfaces of the structure S and the substrate 84 by using the first member 80 as a mask. Thereby, the surface treatment layer F is formed. Thereby, local surface treatment can be accurately performed only on the exposed surfaces of the structure S and the substrate 84. Through the surface treatment, the surface treatment layer F is locally formed only on a part of the surface of the structure S and the substrate 84.

Examples of the surface treatment include vacuum film formation treatment, coating treatment, ion irradiation treatment, etching treatment, and blasting treatment.

Examples of the vacuum film formation treatment include vacuum vapor deposition, sputtering, chemical vapor deposition (CVD), and atomic layer deposition (ALD).

Examples of the coating treatment include inkjet and spray coating.

Examples of the ion irradiation treatment include atmospheric pressure plasma treatment, oxygen plasma ashing, and UV ozone treatment.

Examples of the etching treatment include dry etching using gas and wet etching using a chemical liquid.

Examples of the blasting treatment include sandblasting treatment.

The treatment conditions and the treatment device for each of the above-mentioned treatments may be appropriately selected in accordance with properties of the target surface treatment layer F.

### Step of Removing First Member

It is preferable that the method of manufacturing the structure according to the present disclosure includes a step of removing the first member after the surface treatment step. By removing the first member, the structure in which the surface treatment layer is locally formed on the substrate can be obtained.

In a case where the mold A is used, for example, as shown in Figs. 14F and 14G, the substrate 74 and the first member 70 are separated to remove the first member 70. Thereby, the entire structure S, in which the surface treatment layer F is formed on a part of the surface, is exposed on the substrate 74.

In a case where the mold B is used, for example, as shown in Figs. 15F and 15G, the substrate 84 and the first member 80 are separated from each other to remove the first member 80. Thereby, the entire structure S, in which the surface treatment layer F is formed on a part of the surface of the structure S and a part of the surface of the substrate 84, is exposed on the substrate 84.

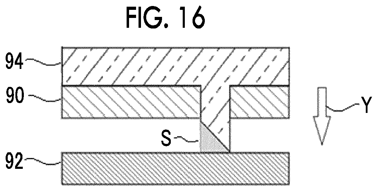

The means for removing the first member by separating the substrate and the first member is not particularly limited, and examples thereof include peeling removal using a hand or an operating device, removal using an extrusion member, dissolution removal using a solvent, and the like. Fig. 16 is a schematic cross-sectional view showing an example of an aspect in which the substrate and the first member are separated from each other by using the extrusion member. In the example shown in Fig. 16, by inserting the protrusion portion of the extrusion member 94 into the structure S subjected to the surface treatment on the substrate 92 from the through-hole of the first member 90 in the direction of the arrow Y, the structure S is extruded from the first member 90, and thus the substrate 92 and the first member 90 are separated.

### Cleaning Step

The method of manufacturing the structure according to the present disclosure may further include a step of cleaning the surface of the first member or the second member. In particular, in a case where the first member is reused, the residue of the surface treatment is accumulated on the side of the first member facing the second member. Therefore, it is particularly preferable to include a step of cleaning the side of the first member facing the second member in such a case.

The cleaning means is appropriately selected in accordance with the surface treatment means, the material to be adhered, and the like. Examples of the cleaning means include wet cleaning using an acid, an alkali, an organic solvent, or the like; dry ice cleaning; cleaning using a laser; sandblast cleaning; plasma cleaning such as atmospheric pressure plasma and dry etching; and the like.

### Other Steps

The method of manufacturing the structure according to the present disclosure may include other steps in addition to the above-mentioned steps. The other steps can be appropriately set in accordance with the form of the obtained structure and the application aspect. Examples of the other steps include a step of processing the structure (that is, the structure having the surface treatment layer) after the step of removing the first member. Examples of the processing step include sealing the structure (for example, a microchannel) using another member, incorporating the structure into another part, and cementing the structure. The other steps are not limited to the examples.

According to the mold and the method of manufacturing the structure of the present disclosure, it is possible to form a microstructre and to perform surface treatment on a part of the surface of the structure. Therefore, the mold and the method of manufacturing the structure of the present disclosure can be usefully applied to medical/bio-applications such as a microchannel and a cell culture vessel; optical applications such as a microlens and a micromirror; and the like.

### Explanation of References

100, 110, 120, 130, 200, 400, 500, 600, 700: mold
10, 10A, 20, 40, 50, 60, 70, 80, 90: first member
12, 12A, 12B, 22, 42, 52, 62, 72, 82: second member
13: protrusion portion
14, 24: through-hole
15: non-through-hole
16, 26, 66: fitting portion
18: pattern portion
28: room
44, 74, 80, 92: substrate
46: permanent magnet
54: non-transparent substrate
64: alignment portion
94: extrusion member
a, b: length
α: angle α
β: angle β
A: wall surface A
B: wall surface B
A₀: wall surface A₀
B₀: wall surface B₀
F: surface treatment layer
G: surface treatment
L: light
S: structure
T: transfer material
X: release layer
Y: Y direction

## Claims

1. A method of manufacturing a structure comprising:
a step of providing a transfer material;
a step of shaping the transfer material on a substrate by using a mold (100, 120, 130, 200, 400, 500, 600, 700) for structure shaping, which has a first member (10, 10A, 20, 40, 50, 60, 70, 80, 90) that has two main surfaces and a through-hole (14) which penetrates through the main surfaces and a second member (12, 12B, 22, 42, 52, 62, 72, 82) that blocks the through-hole, and in which the first member (10, 10A, 20, 40, 50, 60, 70, 80, 90) and the second member (12, 12B, 22, 42, 52, 62, 72, 82) are combined such that a wall surface A, which is a part of a surface of the first member (10, 10A, 20, 40, 50, 60, 70, 80, 90), and a wall surface B, which is a part of a surface of the second member (12, 12B, 22, 42, 52, 62, 72, 82), are made continuous to form a mold wall;
a step of exposing a part of a surface of the structure shaped from the transfer material by removing the second member (12, 12B, 22, 42, 52, 62, 72, 82) from the mold; and
a step of performing surface treatment on the exposed surface of the structure.

2. The method according to claim 1, wherein the step of performing the surface treatment is performed without separating the first member (10, 10A, 20, 40, 50, 60, 70, 80, 90) and the structure.

3. The method according to claim 1 or 2, wherein in the step of performing the surface treatment, the exposed surface of the structure is subjected to the surface treatment by using the first member (10, 10A, 20, 40, 50, 60, 70, 80, 90) as a mask.

4. The method according to claim 1 or 2, wherein the surface treatment is a vacuum film formation treatment, a coating treatment, an ion irradiation treatment, an etching treatment, or a blasting treatment.

5. The method according to claim 1 or 2, wherein the step of shaping the transfer material includes pressing the transfer material provided onto the substrate by using the mold.

6. The method according to claim 1 or 2, wherein the step of shaping the transfer material includes filling the mold with the transfer material and then disposing the mold on the substrate.

7. The method according to claim 1 or 2, wherein the step of shaping the transfer material includes filling the first member (10, 10A, 20, 40, 50, 60, 70, 80, 90) disposed on the substrate with the transfer material, forming the mold by disposing the second member (12, 12B, 22, 42, 52, 62, 72, 82) on the first member (10, 10A, 20, 40, 50, 60, 70, 80, 90) filled with the transfer material, and pressing the formed mold.

8. The method according to any one of claims 1 to 7, wherein the shaping of the transfer material includes at least one selected from the group consisting of curing and photocuring having a curing temperature of -65°C or higher and 300°C or lower.

9. The method according to any one of claims 1 to 8, wherein the step of shaping the transfer material includes immobilizing the first member (10, 10A, 20, 40, 50, 60, 70, 80, 90) of the mold and the substrate by using magnetic force.

10. The method according to any one of claims 1 to 9, further comprising a step of cleaning a side of the first member (10, 10A, 20, 40, 50, 60, 70, 80, 90) facing the second member (12, 12B, 22, 42, 52, 62, 72, 82).

## Patentansprüche

1. Verfahren zur Herstellung einer Struktur umfassend:
einen Schritt des Bereitstellens eines Transfermaterials;
einen Schritt des Formens des Transfermaterials auf einem Substrat unter Verwendung einer Form (100, 120, 130, 200, 400, 500, 600, 700) zur Strukturformung, die ein erstes Element (10, 10A, 20, 40, 50, 60, 70, 80, 90), das zwei Hauptoberflächen und ein Durchgangsloch (14) aufweist, das die Hauptoberflächen durchdringt, und ein zweites Element (12, 12B, 22, 42, 52, 62, 72, 82), das das Durchgangsloch blockiert, aufweist und wobei das erste Element (10, 10A, 20, 40, 50, 60, 70, 80, 90) und das zweite Element (12, 12B, 22, 42, 52, 62, 72, 82) so kombiniert sind, dass eine Wandfläche A, die ein Teil einer Oberfläche des ersten Elements (10, 10A, 20, 40, 50, 60, 70, 80, 90) ist, und eine Wandfläche B, die ein Teil einer Oberfläche des zweiten Elements (12, 12B, 22, 42, 52, 62, 72, 82) ist, durchgehend gemacht werden, um eine Formwand zu bilden;
einen Schritt des Freilegens eines Teils einer Oberfläche der aus dem Transfermaterial geformten Struktur durch Entfernen des zweiten Elements (12, 12B, 22, 42, 52, 62, 72, 82) aus der Form; und
einen Schritt des Durchführens einer Oberflächenbehandlung auf der freigelegten Oberfläche der Struktur.

2. Verfahren gemäß Anspruch 1, wobei der Schritt des Durchführens der Oberflächenbehandlung durchgeführt wird, ohne das erste Element (10, 10A, 20, 40, 50, 60, 70, 80, 90) und die Struktur zu trennen.

3. Verfahren gemäß Anspruch 1 oder 2, wobei bei dem Schritt des Durchführens der Oberflächenbehandlung die freiliegende Oberfläche der Struktur der Oberflächenbehandlung unter Verwendung des ersten Elements (10, 10A, 20, 40, 50, 60, 70, 80, 90) als Maske unterzogen wird.

4. Verfahren gemäß Anspruch 1 oder 2, wobei die Oberflächenbehandlung eine Vakuumfilmbildungsbehandlung, eine Beschichtungsbehandlung, eine Ionenbestrahlungsbehandlung, eine Ätzbehandlung oder eine Strahlbehandlung ist.

5. Verfahren gemäß Anspruch 1 oder 2, wobei der Schritt des Formens des Transfermaterials Pressen des bereitgestellten Transfermaterials auf das Substrat unter Verwendung der Form umfasst.

6. Verfahren gemäß Anspruch 1 oder 2, wobei der Schritt des Formens des Transfermaterials Füllen der Form mit dem Transfermaterial und dann Anordnen der Form auf dem Substrat umfasst.

7. Verfahren gemäß Anspruch 1 oder 2, wobei der Schritt des Formens des Transfermaterials Füllen des ersten Elements (10, 10A, 20, 40, 50, 60, 70, 80, 90), das auf dem Substrat angeordnet ist, mit dem Transfermaterial, Bilden der Form durch Anordnen des zweiten Elements (12, 12B, 22, 42, 52, 62, 72, 82) auf dem ersten Element (10, 10A, 20, 40, 50, 60, 70, 80, 90), das mit dem Transfermaterial gefüllt ist, und Pressen der gebildeten Form umfasst.

8. Verfahren gemäß einem der Ansprüche 1 bis 7, wobei das Formen des Transfermaterials mindestens eines ausgewählt aus der Gruppe bestehend aus Härten und Photohärten mit einer Härtungstemperatur von -65°C oder höher und 300°C oder niedriger umfasst.

9. Verfahren gemäß einem der Ansprüche 1 bis 8, wobei der Schritt des Formens des Transfermaterials das Immobilisieren des ersten Elements (10, 10A, 20, 40, 50, 60, 70, 80, 90) der Form und des Substrats durch Anwendung magnetischer Kraft umfasst.

10. Verfahren gemäß einem der Ansprüche 1 bis 9, ferner umfassend einen Schritt des Reinigens einer Seite des ersten Elements (10, 10A, 20, 40, 50, 60, 70, 80, 90), die dem zweiten Element (12, 12B, 22, 42, 52, 62, 72, 82) zugewandt ist.

## Revendications

1. Procédé de fabrication d'une structure comprenant :
une étape consistant à fournir un matériau de transfert ;
une étape consistant à conformer le matériau de transfert sur un substrat en utilisant un moule (100, 120, 130, 200, 400, 500, 600, 700) pour un conformage de structure, qui a un premier élément (10, 10A, 20, 40, 50, 60, 70, 80, 90) qui a deux surfaces principales et un trou traversant (14) qui pénètre à travers les surfaces principales, et un second élément (12, 12B, 22, 42, 52, 62, 72, 82) qui bloque le trou traversant, et dans lequel le premier élément (10, 10A, 20, 40, 50, 60, 70, 80, 90) et le second élément (12, 12B, 22, 42, 52, 62, 72, 82) sont combinés de telle sorte qu'une surface de paroi A, qui est une partie d'une surface du premier élément (10, 10A, 20, 40, 50, 60, 70, 80, 90), et une surface de paroi B, qui est une partie d'une surface du second élément (12, 12B, 22, 42, 52, 62, 72, 82), sont rendues continues pour former une paroi de moules ;
une étape consistant à exposer une partie d'une surface de la structure conformée à partir du matériau de transfert en enlevant le second élément (12, 12B, 22, 42, 52, 62, 72, 82) hors du moule ; et
une étape consistant à effectuer un traitement de surface sur la surface exposée de la structure.

2. Procédé selon la revendication 1, dans lequel l'étape consistant à effectuer le traitement de surface est effectuée sans séparer le premier élément (10, 10A, 20, 40, 50, 60, 70, 80, 90) et la structure.

3. Procédé selon la revendication 1 ou 2, dans lequel, dans l'étape consistant à effectuer le traitement de surface, la surface exposée de la structure est soumise au traitement de surface en utilisant le premier élément (10, 10A, 20, 40, 50, 60, 70, 80, 90) comme masque.

4. Procédé selon la revendication 1 ou 2, dans lequel le traitement de surface est un traitement de formation de film sous vide, un traitement de revêtement, un traitement d'irradiation ionique, un traitement de gravure, ou un traitement de décapage par projection d'abrasif.

5. Procédé selon la revendication 1 ou 2, dans lequel l'étape consistant à conformer le matériau de transfert inclut de presser le matériau de transfert prévu jusque sur le substrat en utilisant le moule.

6. Procédé selon la revendication 1 ou 2, dans lequel l'étape consistant à conformer le matériau de transfert inclut de remplir le moule avec le matériau de transfert et ensuite de disposer le moule sur le substrat.

7. Procédé selon la revendication 1 ou 2, dans lequel l'étape consistant à conformer le matériau de transfert inclut de remplir le premier élément (10, 10A, 20, 40, 50, 60, 70, 80, 90) disposé sur le substrat avec le matériau de transfert, de former le moule en disposant le second élément (12, 12B, 22, 42, 52, 62, 72, 82) sur le premier élément (10, 10A, 20, 40, 50, 60, 70, 80, 90) rempli avec le matériau de transfert, et de presser le moule formé.

8. Procédé selon l'une quelconque des revendications 1 à 7, dans lequel le conformage du matériau de transfert inclut au moins une opération sélectionnée parmi le groupe constitué de : durcissement et photodurcissement ayant une température de durcissement de -65 °C ou plus élevée et de 300 °C ou plus basse.

9. Procédé selon l'une quelconque des revendications 1 à 8, dans lequel l'étape consistant à conformer le matériau de transfert inclut d'immobiliser le premier élément (10, 10A, 20, 40, 50, 60, 70, 80, 90) du moule et le substrat en utilisant une force magnétique.

10. Procédé selon l'une quelconque des revendications 1 à 9, comprenant en outre une étape consistant à nettoyer un côté du premier élément (10, 10A, 20, 40, 50, 60, 70, 80, 90) faisant face au second élément (12, 12B, 22, 42, 52, 62, 72, 82).
